## Europäisches Patentamt
## European Patent Office
## Office européen des brevets

(11) Numéro de publication: **0 230 168**
**B1**

(12)

# FASCICULE DE BREVET EUROPEEN

(45) Date de publication du fascicule du brevet:
05.09.90

(51) Int. Cl.⁵: **G01R 33/36**

(21) Numéro de dépôt: 86402619.0

(22) Date de dépôt: 25.11.86

(54) Dispositif et procédé de réglage d'une antenne radiofréquence d'un appareil de résonance magnétique nucléaire.

(30) Priorité: 29.11.85 FR 8517722

(43) Date de publication de la demande:
29.07.87 Bulletin 87/31

(45) Mention de la délivrance du brevet:
05.09.90 Bulletin 90/36

(84) Etats contractants désignés:
DE GB NL

(56) Documents cités:
EP-A- 0 047 065
EP-A- 0 073 614
EP-A- 0 142 760
EP-A- 0 173 363
WO-A-84/00214
US-A- 4 095 168
US-A- 4 110 685
US-A- 4 411 270

JOURNAL OF PHYSICS E-SCIENTIC INSTRUMENTS,
vol. 14, no. 6, juin 1981, pages 700-701, Londres, GB; M.
PERIC et al.: "Simple RF matching for NMR coils in
ENDOR spectrometers"

(73) Titulaire: GENERAL ELECTRIC CGR S.A., 100, rue
Camille-Desmoulins, F-92130 Issy les Moulineaux(FR)

(72) Inventeur: Encellaz, Robert, THOMSON-CSF
SCPI 19, avenue de Messine, F-75008 Paris(FR)
Inventeur: Ngtong, Yong Chin Hon, THOMSON-CSF
SCPI 19, avenue de Messine, F-75008 Paris(FR)

(74) Mandataire: Schmit, Christian Norbert Marie et al,
Cabinet Ballot-Schmit 7, rue Le Sueur,
F-75116 Paris(FR)

ACTORUM AG

**Description**

La présente invention a pour objet un dispositif et un procédé de réglage d'une antenne radiofréquence d'un appareil de résonance magnétique nucléaire. Elle trouve plus particulièrement son application dans le domaine médical où les examens par résonance magnétique nucléaire (RMN) apportent une aide précieuse aux diagnostics. Elle peut néanmoins trouver son application dans d'autres domaines. Le but de la présente invention est de concourir à la création d'images par les appareils de RMN qui soient plus justes et plus précises.

Un appareil de RMN comporte classiquement des moyens pour soumettre un corps à un champ magnétique constant et intense. Ainsi mis en condition, certaines régions du corps peuvent être excitées par une excitation radiofréquence et induire, lorsque cette excitation cesse, un signal de résonance que l'on mesure et qui comporte des informations utiles à la création d'images de parties du corps. Les moyens pour exciter et mesurer comportent une antenne radiofréquence. Cette antenne est disposée autour du corps à examiner. La charge vue par cette antenne au moment de l'émission, où ce qui revient au même, l'impédance interne du générateur qu'elle constitue au moment de la mesure, dépendent essentiellement du corps soumis à l'examen. D'un corps à un autre elles changent. Pour assurer la meilleure excitation et la meilleure mesure, il est nécessaire d'accorder l'antenne. Par ailleurs l'antenne RMN doit être adaptée à la ligne haute fréquence qui la relie, par l'intermédiaire d'un duplexeur, soit à l'émetteur soit au récepteur. Il faut donc associer à l'antenne un dispositif réglable pour adapter son impédance. En pratique, comme les lignes haute fréquence sont des câbles coaxiaux, caractérisés par leur impédance caractéristique, par exemple de 50 OHMS, on doit par ailleurs régler l'antenne pour qu'elle présente une telle impédance réélle à la fréquence de fonctionnement.

Un tel montage est par exemple décrit dans le document EP-A 0 073 614. Dans ce montage, deux lignes haute fréquence sont même adaptées par deux circuits distincts. Cependant, dans les deux lignes des pertes de désadaptation sont subies tout le long de la ligne du fait que l'adaptation est réalisée juste avant le récepteur.

Un même problème de perte par désadaptation est rencontré dans un document EP-A 0 173 363 où l'adaptation d'impédance n'est faite, là aussi, que juste avant l'entrée du récepteur.

Un montage couramment utilisé pour l'adaptation des antennes utilise deux condensateurs ajustables. Un premier condensateur est monté en parallèle avec l'antenne, il est suivi d'un autre monté en série. Ces deux condensateurs sont classiquement installés à proximité directe de l'antenne elle-même. Ils se trouvent quasiment dans le tunnel de la machine. Ils sont difficilement accessibles et leur réglage se fait ordinairement manuellement à l'aide de deux tiges de renvoi. En effet, dans l'état actuel de la technique, il est impossible de placer dans le tunnel de la machine des moteurs électriques de commande. Ils perturberaient trop les champs magnétiques.

Dans ces conditions le réglage doit toujours rester manuel ce qui est gênant. La solution qui consisterait à rallonger les tiges pour que les moteurs de commande soient éloignés du tunnel de la machine ne paraît pas envisageable à cause de la complexité de la tringlerie que ce choix entraînerait.

La présente invention a pour objet de pallier les inconvénients cités en permettant que l'adaptation de l'antenne soit toujours effectuée, et qu'elle le soit de manière automatique. Dans l'invention on a préréglé en usine les condensateurs d'accord connues pour limiter la désadaptation d'impédance de l'antenne à la ligne. Puis la ligne haute fréquence (dans la pratique un câble coaxial) a été tronçonnée en deux parties : une première partie relativement courte disposée près de l'antenne et une partie plus longue qui la continue et qui est raccordée aux moyens d'émission-réception. Entre ces deux parties on a installé un circuit d'accord d'antenne. Par le préréglage on a cherché à ce que le taux d'ondes stationnaires, TOS, dans la petite partie de la ligne soit limité, par exemple inférieur ou égal à 3,5.

A l'extrémité de la petite partie de la ligne il est alors possible de disposer un circuit d'accord dont les réglages peuvent être fait automatiquement (avec des moteurs électriques parce que, de ce point de vue, l'éloignement est suffisant).

L'invention a pour objet un dispositif de réglage d'un appareil de résonance magnétique nucléaire tel que défini dans la revendication 1.

L'invention a encore pour objet un procédé de réglage d'un appareil de résonance magnétique nucléaire tel que défini dans la revendication 9.

L'invention sera mieux comprise à la lecture de la description qui suit et à l'examen des figures qui l'accompagnent. Elles ne sont données qu'à titre indicatif et nullement limitatif de l'invention. Sur les figures les mêmes repères désignent les mêmes éléments. Elles montrent :

- figure 1 : un appareil de RMN muni du dispositif de l'invention ;
- figures 2a, 2b et 2c : des diagrammes de réglage de composants du circuit d'accord en fonction de la charge présentée par le corps examiné ;
- figure 3 : un organigramme montrant une variante préférée du procédé de réglage.

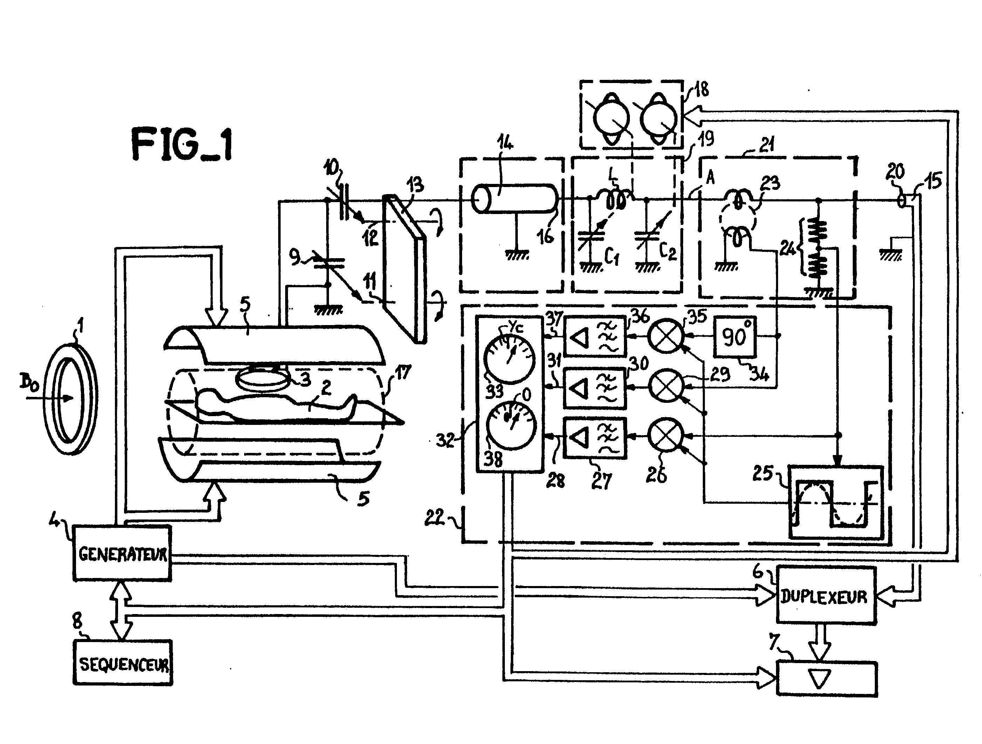

La figure 1 montre un appareil de RMN muni du dispositif de réglage de l'invention. Cet appareil de RMN comporte des moyens 1 pour soumettre un corps examiné 2 à un champ magnétique constant et intense $B_0$. Soumis à cette influence, le corps 2 reçoit encore par une antenne 3 une excitation radiofréquence émise par des moyens générateurs 4. L'appareil comporte en outre des bobines 5 dites de gradient pour particulariser certaines régions du corps 2 à imager. Le signal de résonance émis par le corps 2 est capté par l'antenne 3 et est dirigé, en particulier au moyen d'un duplexeur 6, vers des moyens de réception et de traitement 7. Les moyens générateurs 4 et les moyens de réception 7 sont pilotés par un séquenceur 8. Directement à proximité de l'antenne sont placées des capacités classiques 9 et 10 prévues pour l'accord d'antenne. Dans l'état de la technique, le réglage de ces capacités est effectué au moyen de tiges respectivement 11 et 12 débouchant en face arrière 13 de l'appareil.

Dans l'invention, on a tronçonné la liaison qui raccordait l'antenne 3 (avec son circuit d'accord intrinsèque 9, 10) au duplexeur 6. Cette liaison haute fréquence comporte souvent un cable coaxial dont la tresse est reliée à la masse. Un premier tronçon 14, relativement court, est ainsi suivi d'un deuxième tronçon 15. La longueur du premier tronçon 14 est suffisamment grande pour qu'à son extrémité 16 la plus éloignée du tunnel d'accès 17 de la machine on puisse disposer un dispositif automatique 18 de motorisation d'un circuit 19 interposé d'accord d'antenne. Comme le tronçon 14 n'est pas adapté, il en résulte des pertes supplémentaires, dûes à la désadaptation, en plus des pertes dans le diélectrique et dans le conducteur. On limite ces pertes en limitant la longueur du tronçon au minimum nécessaire et en limitant le TOS dans ce tronçon. La limitation du TOS est obtenue en préréglant les capacités 9 et 10. En pratique, si l'impédance de l'antenne est correctement préréglée, le TOS dans ce tronçon ne dépasse pas 3 dans des cas aussi différents que la présentation à l'examen d'un adulte ou d'un enfant. Les moyens de réception et de traitement 7 sont adaptés à l'impédance caractéristique du tronçon 15 de ligne haute fréquence. Dans un exemple où le champ $B_0$ vaut environ 0,5 Tesla la fréquence de résonance du signal de RMN vaut 21,3 MHz. Avec un câble coaxial du type RX 4/RG 213 U, un tronçon 14 de 3 mètres de long, et si la charge présentée par le corps 2 à l'antenne 3 est adaptée, de l'entrée à la sortie du tronçon 14 le signal de résonance s'atténue de 0,10 dB. Par contre, si cette charge est désadaptée, de telle manière que le taux d'ondes stationnaires dans le tronçon 14 reste sensiblement inférieur à 3,5, l'affaiblissement vaut 0,16 dB. Autrement dit la perte supplémentaire de 0,06 dB est négligeable en contre partie de l'avantage que procure le tronçon 14 : celui de permettre la présence des moyens moteurs 18.

D'une manière préférée, le circuit d'accord 19 est constitué de deux condensateurs ajustables $C_1$ et $C_2$ et d'une inductance L montés en $\pi$. La capacité $C_1$ est la capacité la plus proche du tronçon 14. Pour la commodité des explications qui vont suivre on appelle A la sortie en aval du circuit d'accord 19. Les valeurs des capacités $C_1$ et $C_2$, ainsi que leur plage de réglage et la valeur de la self L sont calculées en fonction du domaine d'impédance de charge qu'on veut adapter. Par exemple, la self L a une valeur de 0,2 microhenry et les capacités $C_1$ et $C_2$ sont des capacités réglables entre 220 picofarad et 720 pF. Le circuit 19 pourrait cependant avoir une autre structure. Par exemple il pourrait comporter plus de trois éléments réactifs. Ou bien, il pourrait comporter un montage en T de deux inductances réglables connectées en série, de part et d'autre condensateur de capacité fixe en parallèle. Le montage en $\pi$ présenté est préféré car il est le plus simple et parce que les condensateurs réglables sont industriellement plus faciles à fabriquer que les inductances réglables.

La procédure de réglage de capacités $C_1$ et $C_2$ est décrite maintenant. Pour cela on raisonne sur les admittances au point A. Dans un premier temps on constate que la capacité $C_2$ ne fait qu'ajouter une admittance purement imaginaire à l'admittance vue du point A. En conséquence, une variation de $C_2$ ne modifie que la partie imaginaire de cette admittance tandis que la partie réelle de cette admittance ne dépend que de la valeur de $C_1$. Cette remarque judicieuse conduit à choisir une procédure particulièrement simple de réglage. Pour adapter l'antenne, il faut alors mesurer la partie réelle et la partie imaginaire de l'admittance vue du point A. La procédure de réglage consiste alors à régler $C_1$ pour que la partie réelle de l'admittance soit égale à l'admittance caractéristique du tronçon 15, et à régler $C_2$ pour annuler la partie imaginaire de cette admittance. On procède d'une manière préférée dans cet ordre puisqu'on peut ainsi aboutir en deux uniques réglages à l'accord d'antenne.

Pour mener à bien ce réglage, on a disposé entre le circuit d'accord 19 et l'entrée 20 du tronçon 15 un capteur 21 relié à un circuit 22 de mesure du désaccord. Le capteur prélève un signal en provenance du générateur (à l'émission) et permet de connaître les caractéristiques tension-courant du signal qui passe par la liaison 14-15 à l'entrée A du circuit 19. Ces caractéristiques sont les mêmes qu'à la réception. Le capteur 21 comporte un transformateur d'intensité 23 pour prélever un signal proportionnel au courant. Il comporte encore un pont diviseur 24 pour prélever un signal proportionnel à la tension. Le circuit 22 de mesure du désaccord comporte un amplificateur-écréteur 25 pour produire un signal, dit carré, synchrone du signal de résonance. Le signal proportionnel à la tension y est introduit, amplifié, puis écrété pour produire un signal alternatif, de composante continue nulle, comportant des impulsions successives égales et de signes contraires.

Le signal proportionnel à la tension du signal d'antenne est introduit dans un premier mélangeur 26 où il est multiplié par le signal carré. Cette multiplication effectue un redressement double alternance. Après un filtrage basse fréquence et une amplification de normalisation dans un premier circuit de mise en forme 27, le signal sortant du mélangeur 26 est transformé en un signal 28 représentatif du module de la tension du signal d'antenne (|V|). Le signal proportionnel au courant du signal d'antenne, prélevé par le transformateur 23, subit un traitement similaire dans un deuxième mélangeur 29 suivi d'un deuxième circuit de mise en forme 30. Compte tenu du déphasage $\phi$ entre le courant et à la tension du signal d'antenne, et compte tenu que les mélangeurs sont attaqués sur leur deuxième entrée par le même signal carré, le circuit de mise en forme 30 délivre un signal 31 proportionnel au produit du module du courant du signal d'antenne par le cosinus de l'angle de déphasage entre le courant et la tension du signal d'antenne (|I| cos $\phi$). Les moyens de mesure 22 comportent encore des moyens de calcul 32 pour effectuer le rapport du signal 31 au signal 28. Le rapport peut être obtenu par exemple en utilisant un microprocesseur spécialisé pour cette fonction ou en utilisant des diviseurs logarithmiques. Ce rapport est égal à la partie réelle $Re_{YA}$ de l'admittance au point A. Les moyens de calcul 32 comportent un afficheur 33 pour afficher cette partie réelle de l'admittance. L'afficheur 33 comporte une indication, $Y_C$, correspondant à l'admittance caractéristique du tronçon 15.

Par ailleurs on fait subir au signal proportionnel au courant un déphasage de 90° et un écrétage de normalisation dans un circuit 34. Puis on fait subir au signal délivré par le circuit 34 un traitement similaire aux traitements précédents en l'introduisant dans un troisième mélangeur 35 suivi d'un troisième circuit de mise en forme 36. Le signal 37 délivré par le circuit 36 est lui aussi introduit dans les moyens 32 de calcul. Ceux-ci comportent en outre un deuxième afficheur 38 représentatif du déphasage φ entre le courant et la tension du signal d'antenne. En effet le signal 37 ainsi transformé est égal au sinus de ce déphasage. Le principe du réglage de $C_1$ et $C_2$ est alors simple : on règle $C_1$ pour que le premier afficheur 33 pointe sur l'indication $Y_C$, puis on régle $C_2$ pour que le deuxième indicateur 38 pointe sur 0. Quand ce dernier pointe sur O, φ est nul, le courant et la tension sont en phase : la partie imaginaire $I_{YA}$ de l'admittance au point A et nulle.

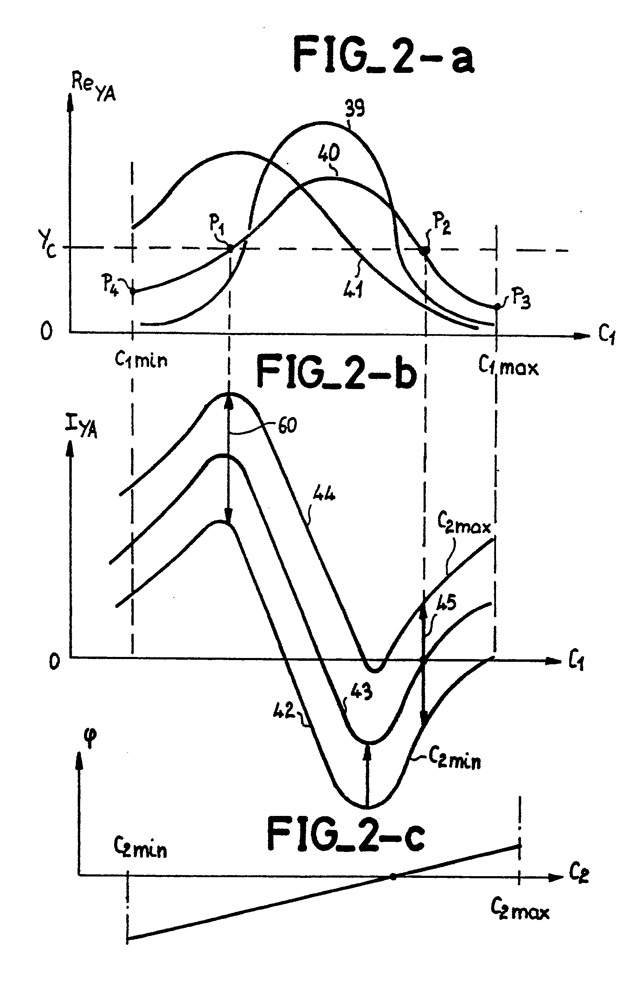

Les figures 2a à 2c montrent les allures respectivement de la partie réelle $Re_{YA}$ de l'admittance au point A, pour trois types différents de corps 2, quand la capacité $C_1$ varie. La figure 2b montre la variation de la partie imaginaire $I_{YA}$ de l'admittance au point A pour un type de corps et avec différentes valeurs de $C_2$ (trois cas), quand $C_1$ varie. La figure 2c montre l'évolution du déphasage φ au point A quand $C_2$ varie. Sur le diagramme de la figure 2a, on a indiqué l'admittance caractéristique $Y_C$. Selon le corps examiné, courbes 39, 40 ou 41, on constate que la partie réelle de l'admittance passe par un maximum situé entre deux minima. La variation de la capacité $C_1$ a été limitée aux valeurs que cette capacité peut prendre dans un exemple pratique de mise en oeuvre. Dans l'exemple préféré, les valeurs $C_{1min}$ et $C_{1max}$ correspondent respectivement à 220 pF et 720 pF. On constate qu'il peut y avoir deux possibilités dans certains cas pour régler $C_1$. En effet le maximum des courbes 39 à 41 est supérieur à $Y_C$, et leurs minima lui sont inférieurs.

Les courbes 39 et 40 correspondent aux cas où il y a deux valeurs de $C_1$ ($P_1$ et $P_2$) pour lesquelles la partie réelle $Re_{YA}$ de l'admittance au point A est égale à $Y_C$. Pour la courbe 41 la plage de variation de $C_1$ vers les faibles valeurs est insuffisante pour atteindre une deuxième fois une égalité entre la partie réelle de l'admittance au point A et l'admittance caractéristique du tronçon 15. En examinant les courbes 42 à 44 de la figure 2b, on constate que pour $P_1$ la partie imaginaire $I_{YA}$ de l'admittance au point A est positive alors que pour $P_2$ elle est négative. Pour $P_1$ il faudrait une self à la place de $C_2$ pour pouvoir annuler la partie imaginaire. Alors que pour $P_2$ on peut annuler la partie imaginaire avec la capacité $C_2$. Donc dans la plupart des cas seul le point de réglage $P_2$ peut satisfaire aux deux conditions $Re_{YA} = Y_C$ et $I_{YA} = 0$.

L'optimisation des capacités $C_1$ et $C_2$ est obtenue quand elles ont une plage de réglage la plus faible pour que toutes les charges correspondant à des ROS limités, par exemple compris entre 1 et 3,5, puissent être concernées. L'optimisation porte sur le coût des capacités réglables. Plus leur plage est faible, moins elles sont chères. Les tois courbes 42 à 44 représentées sur la figure 2b sont paramétrées par des valeurs de $C_2$. Ces courbes 42 à 44 sont comprises entre les courbes correspondant à $C_{2 min}$ et $C_{2 max}$. Une fois le réglage de $C_1$ obtenu la valeur de la partie imaginaire de l'admittance au point A appartient à un segment 45 de valeurs dépendant, pour une valeur $C_1$ donnée, des différentes valeurs de $C_2$. On peut alors annuler $I_{YA}$ en agissant sur $C_2$. Quand $C_2$ varie, la figure 2c nous indique que le déphasage φ passe par une valeur nulle et que l'admittance devient réelle.

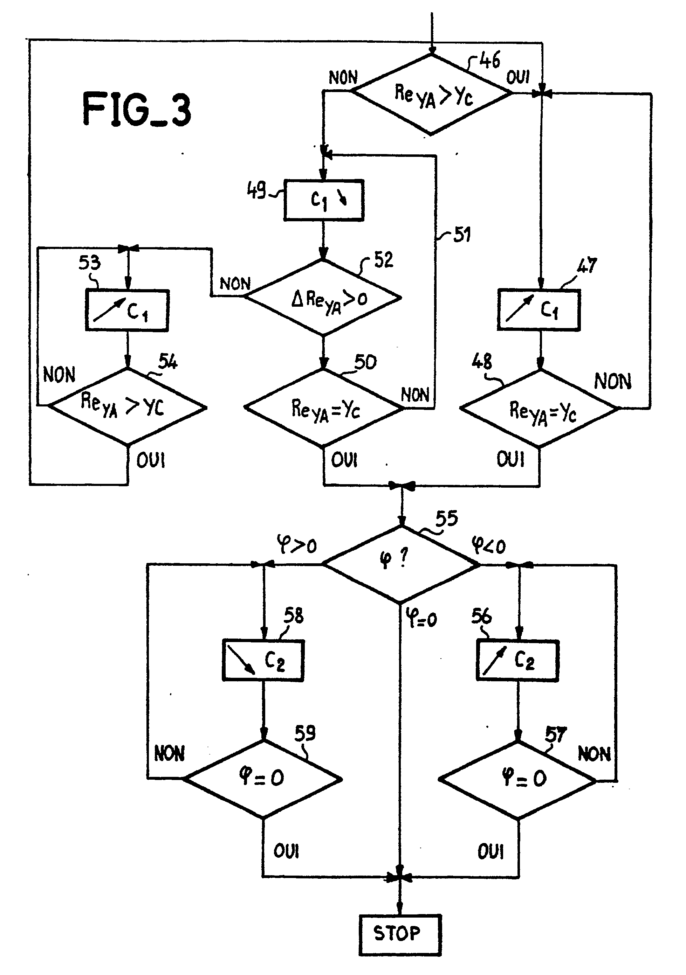

La figure 3 représente un organigramme de traitements automatiques à mettre en oeuvre par l'unité centrale - séquenceur 8 qui reçoit les informations des indicateurs 33 et 38. En fonction de ces mesures, l'unité centrale 8 donne des instructions aux moyens moteurs 18 pour régler les capacités $C_1$ et $C_2$. Le fonctionnement de cet organigramme s'étudie en regardant aussi les figures 2a à 2c. Dans un premier temps, dans un test 46, l'unité centrale compare la valeur de la partie réelle de l'admittance à l'admittance caractéristique. Si cette partie réelle y est supérieure (figure 2a), une instruction 47 d'augmentation de la capacité $C_1$ est adressée aux moyens moteurs 18. Dans un test 48 on étudie le comportement de cette partie réelle de l'admittance par rapport à l'admittance caractéristique. Dès que la valeur de l'admittance caractéristique est atteinte le réglage de $C_1$ est terminé. Par contre si la partie réelle $Re_{YA}$ est inférieure à $Y_C$ ; par une instruction 49 on fait décroître la valeur de la capacité $C_1$. Dans un comparateur 52 on mesure alors l'évolution de $Re_{YA}$. Si cette évolution est positive ($\Delta Re_{YA} > 0$) et tant que la valeur $Y_C$ n'est pas atteinte (test 50), par une boucle 51 le réglage est continué. Dès que cette valeur est atteinte le réglage est arrêté. Ce réglage peut être atteint si au départ $Re_{YA}$ se trouvait entre $P_3$ (figure 2a) et $P_2$. Par contre si $Re_{YA}$ se trouvait entre $P_1$ et $P_4$ la décroissance de $C_1$ amène la variation de $Re_{YA}$ à être négative. Le comparateur 52 détecte cette éventualité. Dans ce cas on augmente $C_1$ par une instruction 53 jusqu'à ce qu'un test 54 indique que $Re_{YA}$ devient supérieur à $Y_C$ : on vient alors de dépasser le point de réglage $P_1$. Dans ce cas d'une manière préférée on décide de rejoindre le point de réglage $P_2$. En effet pour la valeur de $C_1$ ainsi trouvée le segment 60 des valeurs de $I_{YA}$ en fonction de $C_2$ ne comporte pas nécessairement de valeur nulle. Aussi au lieu d'arrêter le réglage de $C_1$ le test 54 débouche dans une séquence comportant l'instruction 47.

Le réglage de $C_1$ étant obtenu, par un test 55, on mesure la valeur du déphasage par rapport à 0. Si ce déphasage est inférieur à 0 il faut augmenter $C_2$ en envoyant une instruction 56 aux moyens moteurs 18. Cette instruction persiste tant qu'un test 57 n'indique pas l'annulation du déphasage. Si ce déphasage, dès le départ, est plus grand que 0, une instruction 58 et un test 59 jouent un rôle dual de l'instruction 56 et du test 57. Dès que le déphasage est annulé, le réglage est terminé. Par contre si le déphasage est nul dès le départ la valeur $C_2$ n'est pas modifiée.

**Revendications**

1. Dispositif de réglage d'un appareil (1–8) de résonance magnétique nucléaire comportant une antenne (3), destinée à émettre et/ou à recevoir d'un corps (2) sous examen dans l'appareil un signal radiofréquence de résonance, cette antenne (3) étant reliée par une ligne haute fréquence à des moyens uniques d'émission-réception, caractérisé en ce que, sur sa liaison entre ladite antenne (3) et lesdits moyens d'émission-réception, cette ligne haute fréquence présente un premier tronçon (14) et un second tronçon (15) montés en série, le premier tronçon (14) étant relié également à l'antenne (3) et le second tronçon (15) étant relié également auxdits moyens d'émission réception, ce dispositif comportant en outre, interposé entre l'antenne (3) et lesdits moyens (15, 6, 7) d'émission réception, un circuit (19) d'accord d'antenne (14) monté en cascade entre les deux tronçons (14, 15) et destiné à adapter l'antenne auxdits moyens d'émission réception.

2. Dispositif selon la revendication 1, caractérisé en ce qu'il comporte en outre, intercalé entre le circuit d'accord et les moyens d'émission réception, un capteur (21) pour délivrer une information représentative du signal fourni par l'antenne, ce capteur étant relié à un circuit (22) de mesure du désaccord d'antenne, et des moyens pour régler l'appareil en ajustant le circuit d'accord en fonction des résultats délivrés par le circuit de mesure du désaccord.

3. Dispositif selon la revendication 2, caractérisé en ce que le circuit de mesure du désaccord comporte des moyens (25–33) pour mesurer la partie réelle de l'admittance de l'antenne et des moyens (34–38) pour mesurer le déphasage entre le courant et la tension du signal d'antenne.

4. Dispositif selon la revendication 3, caractérisé en ce que les moyens pour mesurer la partie réelle de l'admittance comporte des moyens (25–26) pour multiplier le signal d'antenne par un signal carré synchrone du signal d'antenne.

5. Dispositif selon la revendication 3 ou selon la revendication 4, caractérisé en ce que les moyens pour mesurer le déphasage comporte des moyens (34) pour déphaser le signal capté proportionnel au courant et pour multiplier (35) ce signal déphasé par un signal carré (25) synchrone du signal d'antenne.

6. Dispositif selon l'une quelconque des revendications 1 à 5, caractérisé en ce que la ligne haute fréquence est un câble coaxial dont l'impédance caractéristique vaut 50 ohms.

7. Dispositif selon l'une quelconque des revendications 1 à 6, caractérisé en ce que le circuit d'accord est un circuit en $\pi$ avec deux condensateurs de capacités réglables ($C_1$, $C_2$) en parallèle aux bornes d'une inductance (L) fixe.

8. Dispositif selon l'une quelconque des revendications 2 à 7, caractérisé en ce que le capteur comporte un circuit de couplage (23) pour capter un signal proportionnel au courant et un pont diviseur (24) pour capter un signal proportionnel à la tension du signal d'antenne.

9. Procédé de réglage d'un appareil de résonance magnétique nucléaire, comportant une antenne (3) pour émettre et/ou recevoir un signal radiofréquence de résonance, relié par une ligne haute fréquence comportant deux tronçons (14, 15) montés en série à des moyens uniques d'émission réception, caractérisé en ce que:
— on utilise une ligne haute fréquence comprenant deux tronçons (14, 15) montés en série,
— on interpose entre l'antenne (3) et les moyens d'émission réception un tronçon (14) de la ligne haute fréquence relié en cascade à un circuit (19) d'accord d'antenne et à un capteur (21), ce capteur étant destiné à délivrer une information représentative du signal fourni par l'antenne (3) et étant lui-même relié d'une part, à l'autre tronçon (15) de la ligne haute-fréquence et, d'autre part, à un circuit (22) de mesure du désaccord d'antenne,
— on règle l'appareil en ajustant le circuit d'accord en fonction des résultats délivrés par le circuit de mesure du désaccord.

10. Procédé de réglage selon la revendication 9, caractérisé en ce que:
— on utilise comme circuit d'accord un montage en $\pi$ de deux condensateurs ($C_1$, $C_2$) réglables montées en parallèle de part et d'autre d'une inductance fixe (L),
— on règle d'abord la capacité du condensateur ($C_1$) le plus proche de la ligne pour rendre la partie réelle de l'admittance, mesurée à l'endroit du capteur, égale à une admittance caractéristique ($Y_c$),
— puis on règle la capacité de l'autre condensateur ($C_2$) pour rendre le courant du signal à l'endroit du capteur en phase avec sa tension.

**Claims**

1. A device (1 through 8) for the regulation of a nuclear magnetic resonance apparatus comprising an antenna (3) adapted to transmit and/or receive an RF resonance signal from a body (2) under examination in the apparatus, said antenna (3) being connected by a high frequency line with single transmission-reception means, characterized in that at its connection between the said antenna (3) and the said transmission-reception means the said high frequency line has a first limb (14) and a second limb (15) placed in series, the first limb (14) being also connected with the antenna (3) and the second limb (15) being also connected with the said transmission-reception means, said device furthermore comprising, interposed between the antenna (3) and the said transmission-reception means (15, 6 and 7), an antenna tuning (14) circuit (19) placed in cascade between these two limbs (14 and 15) adapted to adapt the antenna to the said transmission-reception means.

2. The device as claimed in claim 1, characterized in that it furthermore comprises, placed between the tuning circuit and the transmission-reception means, a pickup (21) in order to deliver information representative of the signal supplied by the antenna, said pickup being connected with a circuit (22) for measuring the degree of mistuning of the antenna, and means in order to regulate the device by adjusting the tuning circuit as a function of the results supplied by the circuit for measuring mistuning.

3. The device as claimed in claim 2, characterized in that the circuit for measuring mistuning comprises means (25 through 33) in order to measure the real part of the admittance of the antenna and means (34 through 38) in order to measure the degree the current and voltage of the antenna signal are out of phase.

4. The device as claimed in claim 3, characterized in that the means for measuring the real part of the admittance comprise means (25 through 26) in order to multiply the antenna signal by a square signal which is synchronous with the antenna signal.

5. The device as claimed in claim 3 or in claim 4, characterized in that the means for measuring the said out of phase condition comprise means (34) in order to put the picked up signal out of phase proportionally to the current and to multiply (35) this out of phase signal by a square signal (25) which is synchronous with the antenna signal.

6. The device as claimed in any one of the preceding claims 1 through 5, characterized in that the high frequency line is a coaxial cable whose characteristic impedance has a value of 50 ohms.

7. The device as claimed in any one of the preceding claims 1 through 6, characterized in that the tuning circuit is at $\pi$ circuit with two capacitors ($C_1$ and $C_2$) in parallel with the terminals of a fixed inductance (L).

8. The device as claimed in any one of the preceding claims 2 through 7, characterized in that the pickup comprises a coupling circuit (23) in order to pickup a signal proportional to the current and a dividing bridge (24) in order to pickup a signal proportional to the voltage of the antenna signal.

9. A method for the regulation of a nuclear magnetic resonance apparatus, comprising an antenna (3) in order to transmit and/or receive a radio frequency resonance signal, connected by a high frequency line comprising two limbs (14 and 15) connected in series and single means for transmission and reception, characterized by:
– the utilization of a high frequency line comprising two limbs (14 and 15) placed in series,
– the interposition between the antenna (3) and the transmission-reception means of a limb (14) of the high frequency line connected in cascade with an antenna tuning circuit (19) and of a pickup (21), said pickup being adapted to supply information representative of a signal supplied by the antenna (3) and being itself connected on the one hand with the other limb (15) of the high frequency line and on the other with a circuit (22) for measuring the degree of mistuning of the antenna,
– and regulation of the device by adjusting the tuning circuit as function of the results supplied by the circuit for measuring the degree of mistuning.

10. The method of regulation as claimed in claim 9, characterized by:
– the utilization as a tuning circuit of a $\pi$ assembly of two variable capacitors ($C_1$ and $C_2$) placed in parallel on the two sides of a fixed inductance (L),
– the initial regulation of the capacitance of the nearest capacitor ($C_1$) of the line in order to render the real part of the admittance, measured at the position of the pickup, equal to a characteristic admittance ($Y_c$), and
– then the regulation of the capacitance of the capacitor ($C_2$) in order to render the signal at the position of the pickup in phase with its voltage.

## Patentansprüche

1. Vorrichtung zur Justierung eines magnetischen Kernresonanzapparates (1–8) mit einer Antenne (3), die dazu dient, von einem im Apparat in Untersuchung befindlichen Körper (2) ein Resonanz-Funkfrequenzsignal zu senden und/oder zu empfangen, wobei diese Antenne (3) durch eine Hochfrequenzleitung mit einzigen Sende-/Empfangsmitteln verbunden ist, dadurch gekennzeichnet, daß diese Hochfrequenzleitung auf ihrer Verbindung zwischen dieser Antenne (3) und diesen Sende-/Empfangsmitteln einen in Serie geschalteten ersten Abschnitt (14) und zweiten Abschnitt (15) aufweist, wobei der erste Abschnitt (14) ebenfalls mit der Antenne (3) verbunden ist, und der zweite Abschnitt (15) ebenfalls mit diesen Sende-/Empfangsmitteln verbunden ist, wobei diese Vorrichtung außerdem, zwischen die Antenne und diese Sende-/Empfangsmittel (15, 6, 7) geschaltet, einen Schaltkreis (19) zur Antennenabstimmung (14) umfaßt, der zwischen den beiden Abschnitten (14, 15) in Kaskade geschaltet ist und dazu bestimmt ist, die Antenne an diese Sende-/Empfangsmittel anzupassen.

2. Vorrichtung nach Anspruch 1, dadurch gekennzeichnet, daß sie außerdem, eingefügt zwischen dem Abstimmkreis und den Sende-/Empfangsmitteln, einen Fühler (21) umfaßt, um eine für das von der Antenne abgegebene Signal repräsentative Information abzugeben, wobei diesen Fühler mit einem Schaltkreis (22) für die Messung der Antennenverstimmung verbunden ist, sowie Mittel, um den Apparat durch Justierung des Abstimmkreises in Abhängigkeit von den vom Verstimmungsmeßkreis abgegebenen Ergebnissen abzugleichen.

3. Vorrichtung nach Anspruch 2, dadurch gekennzeichnet, daß der Verstimmungsmeßkreis Mittel (25–33) zur Messung des reellen Anteils der Admittanz der Antenne und Mittel (34–38) zur Messung der Phasenverschiebung zwischen dem Strom und der Spannung des Antennensignals umfaßt.

4. Vorrichtung nach Anspruch 3, dadurch gekennzeichnet, daß die Mittel zur Messung des reellen Anteils der Admittanz Mittel (25–26) umfassen, um das Antennensignal mit einem Rechtecksignal zu multiplizieren, das mit dem Antennensignal synchron ist.

5. Vorrichtung nach Anspruch 3 oder nach Anspruch 4, dadurch gekennzeichnet, daß die Mittel zur Messung der Phasenverschiebung Mittel (34) umfassen, um das empfangene Signal proportional zum Strom zu verschieben und dieses phasenverschobene Signal mit einem Rechtecksignal (25) zu multiplizieren (35), das mit dem Antennensignal synchron ist.

6. Vorrichtung nach einem der Ansprüche 1 bis 5, dadurch gekennzeichnet, daß die Hochfrequenzleitung ein Koaxialkabel ist, dessen Kennwiderstand 50 Ohm entspricht.

7. Vorrichtung nach einem der Ansprüche 1 bis 6, dadurch gekennzeichnet, daß der Abstimmkreis ein $\pi$-Kreis mit zwei parallel an die Anschlüsse einer festen Induktanz (L) geschalteten Kondensatoren einstellbarer Kapazitäten ($C_1$, $C_2$) ist.

8. Vorrichtung nach einem der Ansprüche 2 bis 7, dadurch gekennzeichnet, daß der Fühler einen Schaltkreis (23) zum Empfang eines Signals umfaßt, das proportional zum Strom ist, sowie eine Teilerbrücke (24) zum Empfang eines Signals, das proportional zur Spannung des Antennensignals ist.

9. Verfahren zur Justierung eines magnetischen Kernresonanzapparates mit einer Antenne (3), um ein Resonanz-Funkfrequenzsignal zu senden und/oder zu empfangen, die durch eine zwei in Serie geschaltete Abschnitte (14, 15) umfassende Hochfrequenzleitung mit einzigen Sende-/Empfangsmitteln verbunden ist, dadurch gekennzeichnet, daß:
— eine zwei in Serie geschaltete Abschnitte (14, 15) umfassende Hochfrequenzleitung verwendet wird,
— zwischen die Antenne (3) und die Sende-/Empfangsmittel ein Abschnitt (14) der Hochfrequenzleitung geschaltet wird, der in Kaskade mit einem Antennenabstimmkreis (19) und einem Fühler (21) verbunden ist, wobei dieser Fühler dazu bestimmt ist, eine für das von der Antenne (3) abgegebene Signal repräsentative Information abzugeben und seinerseits zum einen mit dem anderen Abschnitt (15) der Hochfrequenzleitung und zum anderen mit einem Antennenverstimmungsmeßkreis (22) verbunden ist,
— der Apparat durch Justierung des Abstimmkreises in Abhängigkeit von den vom Verstimmungsmeßkreis abgegebenen Ergebnissen abgestimmt wird.

10. Justierungsverfahren nach Anspruch 9, dadurch gekennzeichnet, daß:
— als Abstimmkreis eine $\pi$-Schaltung von zwei einstellbaren Kondensatoren ($C_1$, $C_2$) verwendet wird, die beiderseits einer festen Induktanz (L) parallelgeschaltet sind,
— zunächst die Kapazität des der Leitung am nächsten gelegenen Kondensators ($C_1$) eingestellt wird, um den reellen Anteil der an der Stelle des Fühlers gemessenen Admittanz mit einer Nenn-Admittanz ($Y_c$) abzugleichen,
— danach die Kapazität des anderen Kondensators ($C_2$) eingestellt wird, um den Strom des Signals an der Stelle des Fühlers mit seiner Spannung phasengleich zu machen.

**FIG_1**

EP 0 230 168 B1

# FIG_2-a

# FIG_2-b

# FIG_2-c

FIG_3